# EUROPÄISCHE PATENTSCHRIFT

(11) **EP 1 192 376 B1**
(45) Veröffentlichungstag und Bekanntmachung des Hinweises auf die Patenterteilung: **26.11.2003**
(21) Anmeldenummer: 00945546.0
(22) Anmeldetag: 20.05.2000
(51) Int. Cl.: F16K 31/00

(54) **PIEZOAKTOR**
PIEZO-ACTUATOR
ACTIONNEUR PIEZO-ELECTRIQUE

(30) Priorität: 19.06.1999 DE 19928187
(43) Veröffentlichungstag der Anmeldung: 03.04.2002
(73) Patentinhaber: ROBERT BOSCH GMBH, 70442 Stuttgart (DE)
(72) Erfinder: BOECKING, Friedrich, D-70499 Stuttgart (DE)
(86) Internationale Anmeldenummer: DE0001629
(87) Internationale Veröffentlichungsnummer: WO00079162

(56) Entgegenhaltungen:
- EP-A- 0 165 407
- EP-A- 0 844 678
- DE-A- 19 753 930

## Beschreibung

### Stand der Technik

Die Erfindung betrifft einen Piezoaktor, beispielsweise zur Betätigung eines mechanischen Bauteils wie ein Ventil oder dergleichen, nach den gattungsgemäßen Merkmalen des Hauptanspruchs. Ein derartiger Piezoaktor ist allgemein bekannt, siehe z.B. DE-A-197 53 930 oder EP-A-844 678.

Es ist allgemein bekannt, dass unter Ausnutzung des sogenannten Piezoeffekts ein Piezoelement aus einem Material mit einer geeigneten Kristallstruktur aufgebaut werden kann. Bei Anlage einer äußeren elektrischen Spannung erfolgt eine mechanische Reaktion des Piezoelements, die in Abhängigkeit von der Kristallstruktur und der Anlagebereiche der elektrischen Spannung einen Druck oder Zug in eine vorgebbare Richtung darstellt. Der Aufbau dieses Piezoaktors kann hier in mehreren Schichten erfolgen (Multilayer-Aktoren), wobei die Elektroden, über die die elektrische Spannung aufgebracht wird, jeweils zwischen den Schichten angeordnet werden. Beim Betrieb des Piezoaktors ist darauf zu achten das durch mechanische Spannungen im Lagenaufbau keine störenden Rissbildungen entstehen.

### Vorteile der Erfindung

Der eingangs beschriebene Piezoaktor, der beispielsweise zur Betätigung eines mechanischen Bauteils verwendbar sein kann, ist in vorteilhafter Weise mit einem Mehrschichtaufbau von Piezolagen und dazwischen angeordneten Elektroden aufgebaut. Bei einer wechselseitigen seitlichen Kontaktierung der Elektroden entsteht im Bereich zwischen zwei Piezolagen jeweils eine neutrale Phase. Da die jeweils an einer Seite kontaktierten Elektroden kammartig in den Lagenaufbau integriert sind, müssen die in Richtung des Lagenaufbaus aufeinanderfolgenden Elektroden jeweils abwechselnd an gegenüberliegen Seiten kontaktiert werden.

Die an einer Seite kontaktierten Elektroden können dabei in der Regel nicht immer vollständig bis an die gegenüberliegende Seite geführt werden, da sonst Spannungsüberschläge zur zerstörung des Piezoaktors führen können. Bei einer Betätigung des Piezoaktors, d.h. bei Anlage einer Spannung zwischen den im Lagenaufbau gegenüberliegenden Elektroden treten unterschiedliche mechanische Kräfte im Bereich der Elektroden sowie in den nichtkontaktierten neutralen Phasen auf , die zu mechanischen Spannungen und Rissbildungen im Piezoaktor führen können.

Bei der erfindungsgemäßen Ausführungsform wird in vorgegebenen Abständen jeweils eine Elektrodenschicht der Innenelektrode, die an einer Seite kontaktiert ist, vollständig bis an das Ende der anderen Seite geführt und dabei überbrückt die an der jeweils anderen Seite liegende Außenelektrode diese Schicht zur Vermeidung eines Kurzschlusses. Die wechselseitige Kontaktierung ist derart aufgebaut, dass jeweils zwei Innenelektroden, die eine anderspolige Innenelektrode, die auf der gegenüberliegenden Seite kontaktiert ist, einschließen, auf einer Seite gemeinsam kontaktiert sind. Abwechselnd ist nun jeweils eine dieser gemeinsam kontaktierten Innenelektroden unter Bildung einer neutralen Phase nicht bis an das Ende der Piezolagen und die andere bis an das Ende der Piezolage geführt.

Es ist eine Kontaktierung mit Außenelektroden möglich, bei der auf einfache Weise in dem Bereich, in dem die andere, an der nicht kontaktierte Seite bis an das Ende geführte Innenelektrode liegt, eine Isolationsschicht angebracht ist. Die Außenelektroden können dabei aus einem elektrisch leitenden Sieb oder Netz bestehen. Die Form der Außenelektrode kann hier auch ein einfacher Metallstreifen sein, wobei dieser vorzugsweise aus einem leitenden Material mit ähnlichem Ausdehnungskoeffizienten wie das Keramikmaterial der Piezolagen, z.B. Invar, sein kann.

Bei einer anderen bevorzugten Ausführungsform sind jedoch die Außenelektroden vorteilhafterweise Wellelektroden, die die andere, bis an das Ende der Piezolage geführte, nicht zu kontaktierende Innenelektrode in einem vorgegebenen Abstand wellenförmig überbrücken.

Es ist somit mit den zuvor genannten Ausführungsformen möglich, durch das partielle Außenkontaktieren jede zweite Innenelektrode bis nach außen zu führen. Mit dieser Maßnahme und einer partiell abgesetzten Außenelektrode, wie z.B. einer Wellelektrode, die nur im Bereich der Außenkontaktierung angeschlossen ist und zu der nicht zu kontaktierenden Innenelektrode beispielsweise einen Abstand von ca. 50 µm aufweist, kann hier eine Kurzschluss vermieden werden und die Dehnung im Außenbereich, durch die Verkleinerung der neutralen Phasen, insgesamt deutlich erhöht werden, so dass die Gefahr einer Rissbildung vermindert ist.

Es ist weiterhin vorteilhaft, wenn der Mehrschichtaufbau der Piezolagen jeweils am Ende der gefalteten Lagen mit einer elektrisch isolierenden Keramikplatte versehen ist.

Diese und weitere Merkmale von bevorzugten Weiterbildungen der Erfindung gehen außer aus den Ansprüchen auch aus der Beschreibung und den Zeichnungen hervor.

### Zeichnung

Ausführungsbeispiele des erfindungsgemäßen Piezoaktors werden anhand der Zeichnung erläutert. Es zeigen:
Figur 1 einen Schnitt durch einen Piezoaktor mit einem Mehrschichtaufbau von Lagen aus Piezokeramik und mit wechselseitig kontaktierten Innenelektroden und wellförmigen Außenelektroden;
Figur 2 einen Seitenansicht nach der Linie A-A der Figur 1 und
Figur 3 eine Teilansicht eines Ausführungsbeispiels mit isolierten Bereichen im Bereich der jeweils nicht kontaktierten, nach außen geführten Innenelektrode.

### Beschreibung der Ausführungsbeispiele

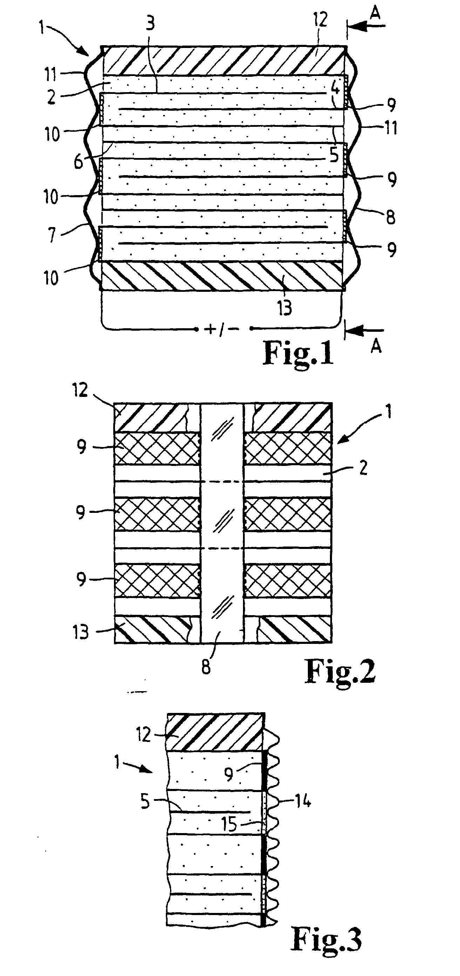

In Figur 1 ist ein Piezoaktor 1 gezeigt, der in an sich bekannter Weise aus Piezofolien 2 eines Quarzmaterials mit einer geeigneten Kristallstruktur aufgebaut ist, so dass unter Ausnutzung des sogenannten Piezoeffekts bei Anlage einer äußeren elektrischen Spannung an Innenelektroden 3 und 4 sowie 5 und 6 etc. über außen kontaktierte Außenelektroden 7 und 8 eine mechanische Reaktion des Piezoaktors 1 erfolgt.

Aus der Figur 1 ist weiterhin ersichtlich, dass die Außenelektroden als Wellelektroden 7 und 8 ausgeführt sind, die an Kontaktflächen 9 und 10 mit jeweils zwei, die gleiche Polarität, aufweisenden Innenelektroden kontaktiert sind. Jede zweite der Innenelektroden mit jeweils gleicher Polarität 3, 5 oder 4, 6 ist bis an das andere Ende des Piezoaktors 1 durchgeführt und hierbei durch eine Welle 11 der jeweiligen nicht zu kontaktierenden Außenelektrode 7 und 8 von dieser isoliert.

Auf die äußeren Piezolagen der Folien 2 ist noch jeweils eine elektrisch isolierende Kopfplatte 12 und eine Fussplatte 13 aufgebracht, durch die der gesamte Piezoaktor 1 nach außen hin abisoliert werden kann.

Zur Verdeutlichung des Ausführungsbeispiels nach der Figur 1 ist in Figur 2 eine Seitenansicht nach A-A aus der Figur 1 gezeigt, bei der die Außenelektrode 3 in der Draufsicht zu erkennen ist. Die gleichen Bauteile sind hier mit den identischen Bezugszeichen versehen.

Aus Figur 3 ist ein zweites Ausführungsbeispiel eines Piezoaktors 1 mit einer anderen Außenkontaktierung 16 zu entnehmen. Hier ist eine einfache Metallfolie 14 als Außenelektrode vorhanden, die im Bereich der nicht zu kontaktierenden Innenelektroden 5 etc. an einer dazwischen angebrachten Isolationsschicht 15 anliegt. Somit kann auch hier der gleiche Effekt, wie beim Ausführungsbeispiel nach den Figuren 1 und 2 erreicht werden.

## Patentansprüche

1. Piezoaktor mit einem Mehrschichtaufbau von Piezolagen (2) und dazwischen angeordneten Innenelektroden (3, 4, 5, 6) und mit einer wechselseitigen seitlichen Kontaktierung dieser Innenelektroden (3, 4, 5, 6) mit Außenelektroden (7, 8; 14) zweier unterschiedlicher Polaritäten, wobei jeweils zwei aufeinanderfolgende Innenelektroden (3, 5) der selben Polarität zwischen sich eine Innenelektrode (4) der jeweils anderen Polarität aufweisen und eine gemeinsame Kontaktstelle (10) mit ihrer zugeordneten Außenelektrode (11) haben, **dadurch gekennzeichnet, daß** eine der beiden Innenelektroden (3. 5) der selben Polarität den Piezoaktor (1) von der Seite ihrer Kontaktierung mit der Außenelektrode (11) zur gegenüberliegenden Seite vollständig durchdringt, während die jeweils andere Innenelektrode (3) der selben Polarität zu der, ihrer Kontaktierung gegenüberliegenden Seite des Piezoaktors (1) outer Bildung einer neutralen Phase mit Abstand endet und wobei die den Piezoaktor (1) vollständig durchdringende Innenelektrode (5) in einem Bereich des Piezoaktors (1) endet, der zur Vermeidung eines Kurzschlußes von der dort angeordneten Außenelektrode (8) überbrückt ist.

2. Piezoaktor nach Anspruch 1, **dadurch gekennzeichnet, daß** in dem Bereich, in dem die von der nicht kontaktierten Seite bis an das Ende geführte Innenelektrode (5) endet, eine Isolationsschicht (15) angebracht ist.

3. Piezoaktor nach Anspruch 1 oder 2, **dadurch gekennzeichnet, daß** die Außenelektroden (14) aus einem elektrisch leitenden Metallstreifen, einem Sieb oder Netz bestehen.

4. Piezoaktor nach einem der Ansprüche 1 bis 3, **dadurch gekennzeichnet, daß** die Außenelektroden aus Wellelektroden (7, 8) bestehen, die die andere, bis an das Ende der Piezolage (2) geführte nicht zu kontaktierende Innenelektrode (5, 6) in einem vorgegebenen Abstand wellenförmig überbrückt.

5. Piezoaktor nach einem der vorhergehenden Ansprüche, **dadurch gekennzeichnet, daß** der Mehrschichtaufbau der Piezolagen (2) jeweils am Ende der Piezolagen (2) mit einer elektrisch isolierenden Keramikplatte (12, 13) versehen ist.

6. Piezoaktor nach einem der vorhergehenden Ansprüche, **dadurch gekennzeichnet, daß** der Piezoaktor (1) zur Betätigung eines mechanischen Bauteils wie ein Ventil oder dergleichen heranziehbar ist.

## Claims

1. Piezo-actuator having a multilayer structure of piezo-layers (2) and internal electrodes (3, 4, 5, 6) arranged between them, and having alternate lateral contact between these internal electrodes (3, 4, 5, 6) and external electrodes (7, 8; 14) with two different polarities, in each case two successive internal electrodes (3, 5) of the same polarity having between them one internal electrode (4) of the respective other polarity and having a common contact point (10) with their assigned external electrode (11), **characterized in that** one of the two internal electrodes (3, 5) of the same polarity completely penetrates the piezo-actuator (1) from the side on which it makes contact with the external electrode (11) to the opposite side, while the respective other internal electrode (3) of the same polarity as the side of the piezo-actuator (1) which is opposite where contact is made ends at a distance, forming a neutral phase, and the internal electrode (5) which completely penetrates the piezo-actuator (1) ends in a region of the piezo-actuator (1) which, in order to avoid a short circuit, is bypassed by the external electrode (8) arranged there.

2. Piezo-actuator according to Claim 1, **characterized in that** an insulation layer (15) is provided in the region in which the internal electrode (5) ends, which electrode extends from the side with which there is no contact as far as the end.

3. Piezo-actuator according to Claim 1 or 2,
**characterized in that** the external electrodes (14) are composed of an electrically conductive metal strip, a sieve or net.

4. Piezo-actuator according to one of Claims 1 to 3, **characterized in that** the external electrodes are composed of corrugated electrodes (7, 8) which are bypassed in a wave shape at a predefined distance by the other internal electrode (5, 6) which extends as far as the end of the piezo-layer (2) and with which contact is not to be made.

5. Piezo-actuator according to one of the preceding claims, **characterized in that** the multilayered structure of the piezo-layers (2) is provided at the end of each of the piezo-layers (2) with an electrically insulating ceramic plate (12, 13).

6. Piezo-actuator according to one of the preceding claims, **characterized in that** the piezo-actuator (1) can be used to activate a mechanical component such as a valve or the like.

## Revendications

1. Actionneur piézo-électrique présentant une structure multicouche de couches piézo-électriques (2) et des électrodes intérieures (3, 4, 5, 6) disposées entre ces couches, ainsi qu'une connexion latérale à double sens entre ces électrodes intérieures (3, 4, 5, 6) et les électrodes extérieures (7, 8 ; 14) de deux polarités différentes, deux électrodes intérieures (3, 5) de polarité identique intercalant entre elles une électrode intérieure (4) de polarité opposée et présentant un point de contact (10) commun les reliant à l'électrode extérieure (11) leur étant associée,
**caractérisé en ce qu'**
une des deux électrodes intérieures (3, 5) de polarité identique traverse de part en part l'actionneur piézo-électrique (1) du côté où elle est connectée à l'électrode extérieure (11) au côté opposé alors que l'autre électrode intérieure (3) de polarité identique s'arrête, par la formation d'une phase neutre, à une certaine distance du côté opposé à sa connexion, et l'électrode intérieure (5) traversant de part en part l'actionneur piézo-électrique (1) s'arrête dans une zone de l'actionneur piézo-électrique (1) présentant un enjambement afin d'éviter un court-circuit de l'électrode extérieure (8) s'y trouvant.

2. Actionneur piézo-électrique selon la revendication 1,
**caractérisé en ce que**
l'on pose une couche isolante (15) dans la zone où s'arrête l'électrode intérieure (5) qui va du côté non connecté à l'extrémité de l'actionneur piézo-électrique (1).

3. Actionneur piézo-électrique selon l'une des revendications 1 ou 2,
**caractérisé en ce que**
les électrodes extérieures ( 14), en forme de bandes de métal conducteur électrique, consistent en un filtre ou en un filet.

4. Actionneur piézo-électrique selon l'une quelconque des revendications 1 à 3,
**caractérisé en ce que**
les électrodes extérieures consistent en des électrodes ondulées (7, 8) qui en formant des ondes enjambent à une certaine distance l'autre électrode intérieure (5, 6) à ne pas connecter et atteignant l'extrémité de la couche piézo-électrique (2).

5. Actionneur piézo-électrique selon l'une quelconque des revendications précédentes,
**caractérisé en ce que**
la structure multicouche des couches piézo-électriques (2) est pourvue, à chaque extrémité de la couche piézo-électrique (2), d'une plaque de céramique (12, 13) isolante électriquement.

6. Actionneur piézo-électrique selon l'une quelconque des revendications précédentes,
**caractérisé en ce que**
l'actionneur piézo-électrique (1) peut servir à commander un composant mécanique tel qu'une vanne ou tout autre composant du même genre.
